Europäisches Patentamt

European Patent Office

Office européen des brevets

(19)

(11) Publication number: 0 254 444

A1

## (12) EUROPEAN PATENT APPLICATION

(21) Application number: 87305919.0

(22) Date of filing: 03.07.87

(51) Int. Cl.⁴: H01L 23/48 , H01L 23/30

The title of the invention has been amended (Guidelines for Examination in the EPO, A-III, 7.3).

(30) Priority: 07.07.86 JP 157918/86

(43) Date of publication of application:
27.01.88 Bulletin 88/04

(84) Designated Contracting States:
DE FR GB

(71) Applicant: Hitachi Maxell Ltd.
No 1-1-88, Ushitora Ibaraki-shi
Osaka-fu(JP)

(72) Inventor: Yamamoto, Hiroshi
3-14 Kubogaoka-3-chome Moriyamachi
Kitasoma-gun Ibaraki-ken(JP)
Inventor: Arakawa, Ryutaro
1468-5 Oaza Furumagi Ishigemachi
Yuki-gun Ibaraki-ken(JP)
Inventor: Yanaka, Yoshimi
2-3-104 Togashira-1-chome
Toride-shi(JP)
Inventor: Fukuda, Tuyoshi
4-7 Kubogaoka-3-chome Moriyamachi
Kitasoma-gun Ibaraki-ken(JP)

(74) Representative: Williams, Trevor John et al
J.A. KEMP & CO. 14 South Square Gray's Inn
London WC1R 5EU(GB)

(54) Moulded integrated-circuit module.

(57) An IC module (20) comprises a tape-like wiring board (4) on which a circuit wiring (6) and connection terminals (5, 8) are formed, and an IC chip (I) directly connected to part (5) of the connection terminals by bump electrodes (2'). The wiring board and the IC chip are integrally molded with a resin (I0, I0', I0").

## FIG. 3

## INTEGRATED CIRCUIT MODULE

### BACKGROUND OF THE INVENTION

This invention relates to semiconductor devices and more particularly to a very thin type semiconductor device in which a tape-like wiring board and an integrated circuit (IC) chip mounted thereto are sealed with resin.

This type of semiconductor device in which a wiring board and an IC chip mounted thereto are sealed with resin has been known and it will hereinafter be referred to as an IC module.

In recent years, a so-called IC card having data processing functions such as a memory function, an operation function and the like has been gaining a wide range of application in various fields. This type of IC card has an IC module embedded in a card substrate and when set in a terminal unit such as a reader/writer unit, it is operated so that the built-in IC module cooperates with the terminal unit to perform processings such as transmission/reception, operation and storage of data.

A conventional IC card has an IC module of a structure as exemplified in Fig. l. The conventional IC module illustrated, in sectional form, in Fig. l comprises an IC chip l, electrodes 2, lead conductors 3, a wiring board 4, connection terminals 5, wiring conductors 6, through-holes 7, contact terminals 8, a reinforcement frame 9 and a sealing resin l0.

A conductor pattern including the wiring conductors 6 and the connection terminals 5 to be connected to the electrodes 2 of the IC chip l is formed on the wiring board 4, the connection terminals 5 are connected to the electrodes of the IC chip l through lead conductors 3 and the wiring conductors 6 are connected to the contact terminals 8 by way of through-holes 7. The IC module is embedded in a card substrate (not shown) to form the IC card having the contact terminals 8 used for electrical connection to the terminal unit. To finish the IC module, the IC chip l electrically connected with the wiring board 4 is sealed with resin l0 as applied in a region defined by the reinforcement frame 9.

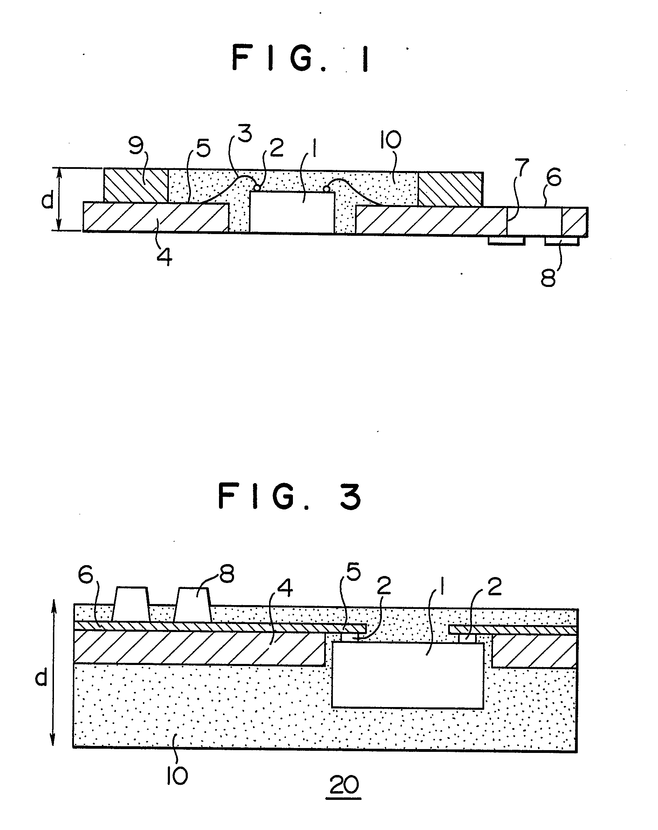

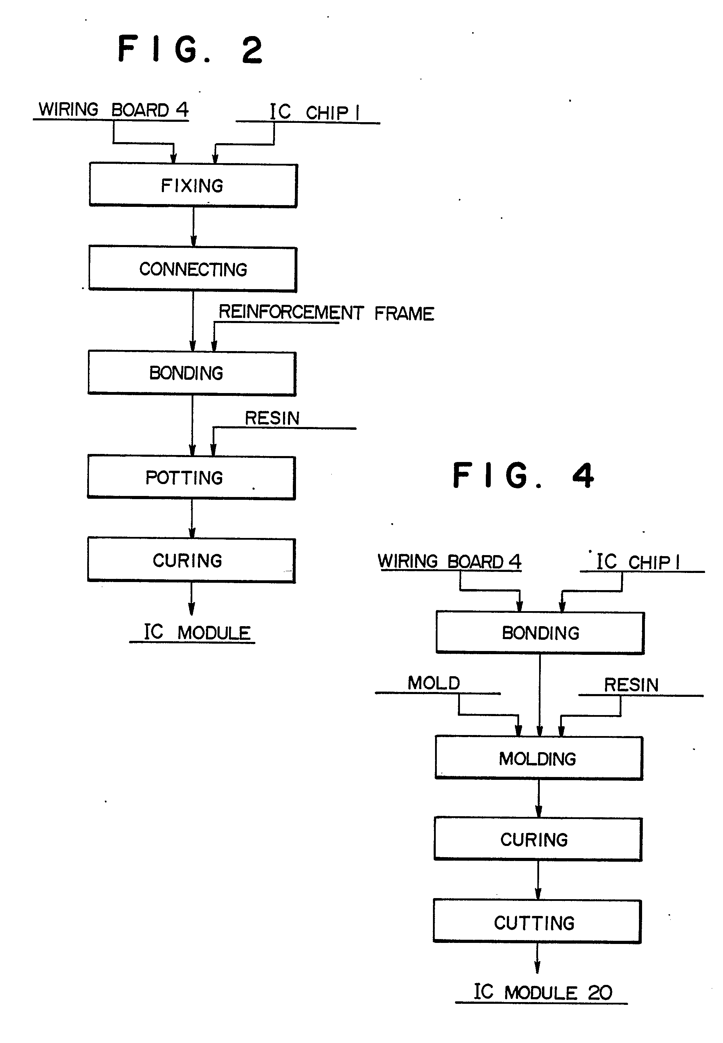

The IC module shown in Fig. l is fabricated through steps as illustrated in Fig. 2.

Referring to Fig. 2, the IC chip l is first fixed to the wiring board 4 patterned with the contact terminals 8, wiring conductors 6 and connection terminals 5, and the connection terminals 5 of the wiring board 4 are connected to the electrodes 2 of the IC chip l by the lead conductors 3. Subsequently, the reinforcement frame 9 is bonded to the wiring board so that it surrounds the IC chip l, and the resin l0 is potted in the region defined by the reinforcement frame 9 to completely seal the IC chip l and lead conductors 3 and then cured to form the IC module.

The IC chip l is formed of silicon which is fragile and desirably, it is protected by covering lower and upper surfaces of the IC chip with plates of large strength. But the overall thickness of the module is limited. For example, when the thickness of an IC card is regulated to be 0.76 mm pursuant to International Orgamization for Standardization (IOS), the overall thickness of a module must be limited to about 0.5 mm or less by taking account of the thickness of a protective cover.

As far as the thickness of the IC module is limited to 0.5 mm or less, it is impossible to provide the lower and upper surfaces of the IC chip with covers.

Further, since the resin l0 potted in the region defined by the reinforcement frame 9 and then cured through the conventional fabrication process becomes a bump rising beyond the top of the reinforcement frame 9, the resin l0 needs to be ground until at least the top of the reinforcement frame 9 so that the IC module is made as thin as possible to ensure a predetermined thickness of the IC module.

However, during grinding, breaking of the lead conductors 3 would occur accidentally and intended reduction in thickness can not be achieved.

As is clear from the foregoing description, the conventional IC module in which the reinforcement frame surrounds the IC chip and the wiring board and the IC chip fixed thereto are sealed with the resin potted in the region defined by the reinforcement frame is disadvantageous in that the back (bottom surface) of the IC chip is bared, proving that reinforcement by only the reinforcement frame applied to the top surface of the wiring board is insufficient and that the reduction in thickness of the IC module can not be so sufficient as to be intended.

### SUMMARY OF THE INVENTION

An object of this invention is to provide a highly reliable, very thin type IC module capable of facilitating attainment of sufficient reinforcement of the IC chip and reduction in thickness of the IC module.

According to this invention, to accomplish the above object, a wiring board is formed with finger-like connection terminals, a plurality of IC chips each having bump-like electrodes are fixed to the wiring board by directly bonding the connection terminals and the bump electrodes, a resulting structure is mounted in a metal mold, a resin is injected into the metal mold through transfer molding process and then cured, and a molded structure is cut to provide IC modules each having one IC chip.

Throughout the thus fabricated IC module, the wiring board and IC chip can be completely sealed with the resin at their lower and upper surfaces to completely reinforce the IC chip, and the IC module can be decreased in thickness without being subjected to grinding.

BRIEF DESCRIPTION OF THE DRAWINGS

Figure I is a sectional view showing a prior art semiconductor device (IC module);

Figure 2 illustrates fabrication steps for the prior art semiconductor device;

Figure 3 is a sectional view showing a semiconductor device or IC module according to an embodiment of the invention;

Figure 4 illustrates fabrication steps for the semiconductor device shown in Fig. 3;

Figure 5 is a fragmentary sectional view showing a plurality of semiconductor devices before separated;

Figure 6 is a sectional view showing a semiconductor device according to a fourth embodiment of the invention;

Figure 7 is a fragmentary sectional view useful in explaining fabrication steps for the semiconductor device shown in Fig. 6; and

Figure 8 is a sectional view showing a semiconductor device according to a fifth embodiment of the invention.

DESCRIPTION OF THE PREFERRED EMBODIMENTS

The invention will now be described by way of example with reference to the accompanying drawings.

Referring to Fig. 3, an IC module according to a first embodiment of the invention and illustrated in sectional form in Fig. 3 comprises an IC chip I, bump electrodes 2', a wiring substrate 4, connection terminals 5, wiring conductors 6, contact terminals 8 and a molded resin I0 for sealing. The IC module is generally designated by reference numeral 20.

The IC chip I is of a thickness of, for example, 0.3 mm and has the bump electrodes 2' each including a bump formed by metallizing on an aluminum pad and an uppermost layer formed on the metalized layer by plating gold.

The wiring board 4 comprises an about 70 μm thick plastic (resin) base film which is made of, for example, glass epoxy, polyimide or polyethylene-terephthalate and takes a tape-like form, and a conductor pattern of copper foil, formed on the base film, for constituting the wiring conductors 6 and for formation of the connection terminals 5 and contact terminals 8. Each of the wiring conductor and connection terminal has a thickness of about 35 μm and the overall thickness of the tape-like wiring board measures about I05 μm. The contact terminal 8 has three layers of copper, nickel and gold laminated on the copper foil in this order through mask plating process and has an appreciable height. The thus constructed contact terminal 8 can have an uppermost end portion which is exposed exteriorly of a resin molded structure of the component members to ensure electrical contact with external units. A single plating process of copper or gold is insufficient to obtain a sufficient height of the contact terminal 8 and so the multi-layer structure is adopted. Formation of the whole contact terminal by using gold alone is desirable from the standpoint of electrical resistance but is costly. Accordingly, the three-layer structure is employed including the uppermost layer of gold meeting requirement for contact resistance, the lowermost layer of copper and the intermediate layer of nickel suitable for connection of the gold and copper layers. This structure can therefore meet requirements of cost and electrical resistance. The connection terminal 5 has a layer of tin formed on the copper foil through mask plating process.

The gold bump electrode 2' of the IC chip I bonded to the connection terminal 5 of the wiring board 4 through gang bonding process establishes gold-tin eutectic bonding.

The whole structure of the wiring board 4 and the IC chip I fixed thereto is molded with a resin I0 through transfer molding process, excepting the upper end portions of the contact terminals 8 to be exposed externally of the structure, to form the very thin IC module 20 in which the IC chip I is securely supported and completely protected. When neglecting the contact terminals 8, the thickness, d, of the IC module can be 0.5 mm or less. Therefore, when this IC module is used for, for example, an IC card, the design margin of the IC card can be sufficient to achieve the 0.76 mm thickness pursuant to the IC card standard even when the formation of the protective cover for the IC card is taken into consideration.

The IC module shown in Fig. 3 may be fabricated through fabrication steps as shown in Fig. 4.

Referring to Fig. 4, the wiring board 4 in the form of an elongated tape which is formed with a great number of IC chip mount portions in the longitudinal direction is continuously fed automatically to a bonder and wound up, so that IC chips sequentially fed also automatically may be fixed to the wiring board at the IC chip mount portions by bonding the bump electrodes and the connection terminals through gang bonding process. This method of bonding is generally called a tape-automated-bonding (TAB) method or a tape-carrier-bonding method.

Subsequently, the tape-like wiring board mounted with the IC chips is cut at invervals of a predetermined length which contains, for example, five IC chips and a cut-out tape-like wiring board mounted with the IC chips is set in a metal mold. Preferably, the metal mold may be designed to accommodate a plurality of cut-out wiring boards at a time to thereby further improve efficiency of working. The metal mold is adapted for molding resin and has cavities each resembling a desired configuration of each IC module. A transfer resin such as epoxy resin plasticized in a transfer chamber is injected into the cavities. This method of molding is called a transfer molding process according to which the plasticizing step of compression molding is carried out in an independent transfer chamber and a plasticized material (resin) is pressurized and injected into closed cavities in a heated metal mold, and is advantageous in that (I) curing time is decreased, (2) curing is uniform and molding distortion is lessened, (3) the number of burrs is lessened, (4) accuracies of dimension are high and (5) parts to be embedded are not damaged.

After the resin is injected into the metal mold through transfer molding process, the injected resin is cured and a resulting structure of the cut-out wiring board is removed from the metal mold and cut again to provide desired IC modules each having a single IC chip.

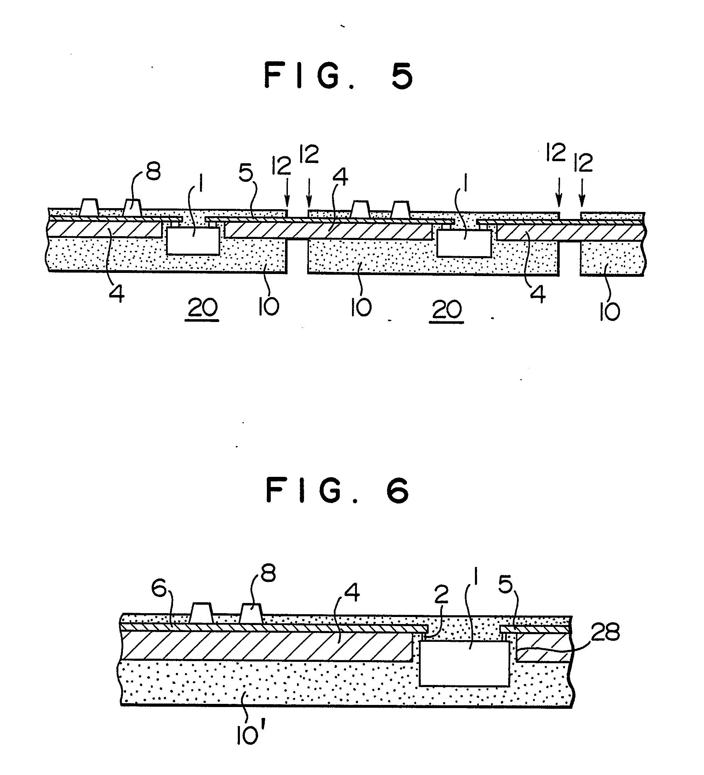

The cut-out wiring board structure with IC modules which has experienced resin injection molding through transfer molding process and has been removed from the metal mold is seen before cutting as illustrated in sectional form in Fig. 5 in which component members like those of Fig. 3 are designated by like reference numerals. The structure is cut at portions I2 to provide individual IC modules 20 having one IC chip I.

Second and third embodiments of the invention will be described.

In the second embodiment, connection terminals 5 to be provided on the tape-like wiring board 4 as illustrated in Fig. 3 are formed by plating solder. Bump electrodes 2' of an IC chip I have each a thick bump of nickel or copper and a gold layer overlying the bump, and the connection terminals 5 are soldered to the bump electrodes 2'.

In the third embodiment, connection terminals 5 to be provided on the tape-like wiring board 4 as illustrated in Fig. 3 are formed on the copper foil pattern by partial plating to take the form of a three-layer lamination structure including a copper layer, a nickel layer and a gold layer laminated in this order, and aluminum pads alone as produced during the IC wafer production process and used, without being applied with aluminum metallization, as electrodes of an IC chip I. The aluminum pads of the IC chip and bumps of the connection terminals of the wiring board are bonded together, establishing gold-aluminum eutectic bonding, to connect the IC chip to the wiring board.

With the exception of the points described above, the second and third embodiments are identical to the first embodiment described earlier.

Turning to Fig. 6, there is illustrated, in sectional view, an IC module according to a fourth embodinent of the invention which comprises a wiring board 4, an IC chip I, electrodes 2, connection terminals 5, wiring conductors 6, contact terminals 8 and a photo-setting resin I0' for sealing.

The wiring board 4 comprises an insulating film made of, for example, glass fiber epoxy or polyimide, and a predetermined conductor pattern of copper foil, formed on one surface of the insulating film, for formation of contact terminals 8 adapted for electrical connection with electrodes (not shown) of a terminal unit and connection terminals 5 adapted for connection to the IC chip I as well as for constituting the wiring conductors 6, the insulating film being opened to form IC chip mount portions 28 at locations corresponding to the connection terminals 5. The contact terminals 8 comprises layers of copper, nickel and gold sequentially laminated in this order on the copper foil patterned on the wiring board 4 and is raised relative to the wiring conductors 6. The connection terminal 5 comprises a layer formed by plating tin on the copper foil patterned on the wiring board 4. The wiring conductors 6 are formed by etching a copper foil laminated on the wiring board 4.

The electrode 2 of the IC chip I has a bump formed by metallizing aluminum on an aluminum pad and an uppermost layer formed by plating gold on the bump. The IC chip I is inserted in the opening of the IC chip mount portion 28, and the electrodes 2 and the connection terminals 5 patterned on the wiring board are bonded together through gang bonding process to form a desired semiconductor circuit.

As the sealing resin 10', a known photo-setting resin such as acryl resin may be used.

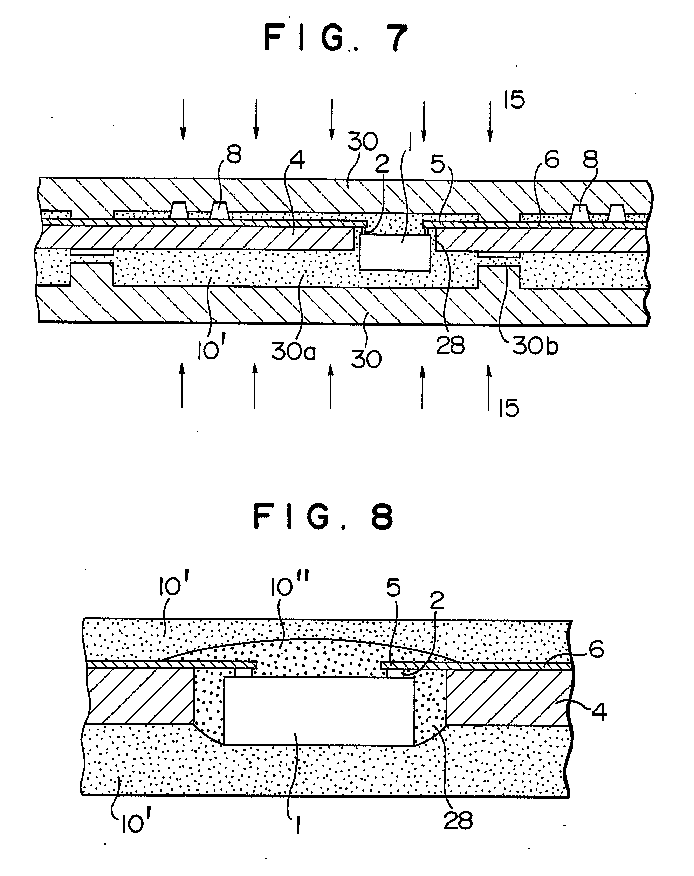

Principally, the IC module of the fourth embodiment can be fabricated through fabrication steps as will be explained with reference to Fig. 7.

Referring to Fig. 7, the connection terminals 5 of the elongated wiring board 4 are bonded to the electrodes 2 of the IC chips 1 inserted in the openings of IC mount portions 28 in the wiring board 4 through gang bonding process, the wiring board 4 mounted with the IC chips is placed in a transparent mold 30 with individual IC modules accommodated in individual cavities 30a of the mold, and the photo-setting resin 10' is injected into the cavities 30a. The resin 10' is allowed to flow from one cavity to another via a hole 30b in communication with adjacent cavities 30a. Subsequently, external light 15 is irradiated on the transparent mold 30 to cure the photo-setting resin 10'. After curing, the transparent mold 30 is disassembled and intended semiconductor devices are removed from the transparent mold.

Referring to Fig. 8, there is illustrated in sectional view an IC module according to a fifth embodiment of the invention which comprises an IC chip 1, electrodes 2 of the IC chip 1, a wiring board 4, connection terminals 5, wiring conductors 6 and resins 10' and 10" for sealing.

The IC chip 1 is inserted in an opening of IC chip mount portion 28 formed in the wiring board 4 and the electrodes 2 of the IC chip 1 are bonded to the connection terminals 5. Thereafter, the first resin 10" is filled in the opening of IC chip mount portion 28 to cover the IC chip 1, its electrodes 2 and connection terminals 5, excepting the bottom surface of the IC chip 1, and the resin 10" is then cured. In this manner, the IC chip 1 and bonded portions of the electrodes 2 and connection terminals 5 can be protected against processings in the subsequent fabrication steps, the IC chip 1 can be protected from humidity and vibration and the IC module can be improved in strength.

After the first resin 10" has been filled and cured, a resulting structure is placed in a mold similar to that of the fourth embodiment and the second resin 10' is injected into the mold to seal the IC chip 1, its electrodes 2 and connection terminals 5 with two layers of resins 10' and 10".

In this embodiment, a transparent ultraviolet-ray setting resin may be used as both the first and second resins 10" and 10' or an opaque resin composition mixed with carbon black or the like may be used as the first resin 10" of the first layer, thereby making it possible to prevent the IC chip 1 exemplarily formed as an EPROM from being damaged by ultraviolet rays.

The second layer of resin 10' in this embodiment may obviously be formed through the same molding process as that for the thermoplastic resin such as epoxy resin used in the first embodiment.

Before placing the wiring board mounted with the IC chips in the metal or transparent mold used for molding IC modules in the embodiments described previously, the inner surface of the mold is coated with a release agent to facilitate removal of the molded IC modules from the mold and consequently improve efficiency of working.

The use of the photo-setting resin such as ultraviolet-ray setting resin as the sealing resin is advantageous in that the photo-setting resin is settable at normal temperatures to facilitate stable fabrication and that the photo-setting resin is less constricted or expanded upon curing at normal temperatures to avoid occurrence of adverse effect such as breaking of bonded portions of the IC chips.

As described above, since according to the invention the IC chips are mounted to TAB (Tape Automated Bonding) substrate and sealed with resin through transfer molding process to form the IC modules, the connection of the mounted IC chip with the wiring board can be robust and minimized in size to reduce the thickness of the IC module per se, the IC chip can be completely protected and reinforced at its upper and lower surfaces with cured resin to avoid such damage as cracking of the IC chip, and the fabrication process can be simplified to reduce fabrication time for IC modules and facilitate automation of the fabrication process, thereby providing highly reliable IC modules of excellent performance which can be freed from prior art disadvantages.

Although in the foregoing embodiments the IC module has been described as applied to the IC card, it may obviously be applied also to data file cards, electronic calculators and other various electronic devices.

## Claims

1. A semiconductor device (20) comprising a wiring board (4), an IC chip (1) mounted to said wiring board and a resin (10, 10', 10") for molding said wiring board and said IC chip together, wherein said wiring board comprises a tape-like resin base film on which a conductor pattern for wiring conductors (6) and connection terminals (5, 8) are formed, said IC chip is connected to part of said connection terminals through bump electrodes

(2'), and said wiring board and said IC chip are molded so as to be integrally sealed with said resin.

2. A semiconductor device according to Claim 1 adapted for IC cards wherein contact terminals (8) for electrical contact with an external unit are formed on part of said conductor pattern on said wiring board, and said wiring board and said IC chip are sealed with said resin such that upper portions of said contact terminals are exposed exteriorly of a sealed structure.

3. A semiconductor device according to Claim 2 adapted for IC cards wherein said wiring board comprises a plastic base film made of a material selected from the group of glass fiber reinforced epoxy, polyimide and polyethylene-terephthalate.

4. A semiconductor device according to Claim 2 adapted for IC cards wherein each of said contact terminals has a multi-layer structure of different kinds of metal.

5. A semiconductor device according to Claim 4 adapted for IC cards wherein each of said contact terminals has a three-layer structure of a copper layer, a nickel layer and a gold layer.

6. A semiconductor device according to Claim 1 wherein said wiring board and said IC chip are molded so as to be integrally sealed with a photo-setting resin.

# F I G. 1

# F I G. 3

20

# FIG. 2

WIRING BOARD 4      IC CHIP 1

```
        ┌──────────────┐
        │    FIXING    │
        └──────┬───────┘
               │
        ┌──────┴───────┐
        │  CONNECTING  │
        └──────┬───────┘
               │
   REINFORCEMENT FRAME
        ┌──────┴───────┐
        │   BONDING    │
        └──────┬───────┘
               │
            RESIN
        ┌──────┴───────┐
        │   POTTING    │
        └──────┬───────┘
               │
        ┌──────┴───────┐
        │   CURING     │
        └──────┬───────┘
               │
          IC MODULE
```

# FIG. 4

WIRING BOARD 4      IC CHIP 1

```
        ┌──────────────┐
        │   BONDING    │
        └──────┬───────┘
               │
   MOLD              RESIN
        ┌──────┴───────┐
        │   MOLDING    │
        └──────┬───────┘
               │
        ┌──────┴───────┐
        │   CURING     │
        └──────┬───────┘
               │
        ┌──────┴───────┐
        │   CUTTING    │
        └──────┬───────┘
               │
         IC MODULE 20
```

# FIG. 5

# FIG. 6

# F I G . 7

# F I G . 8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | FR-A-2 520 541 (FLONIC)<br>* Figures 2-4; page 7, line 13 - page 13, line 6 * | 1,2 | H 01 L 23/48<br>H 01 L 23/30 |
| Y | | 3,4 | |
| A | | 5,6 | |
| | --- | | |
| Y | EP-A-0 071 255 (SIEMENS)<br>* Figure 3; page 6, line 23 - page 7, line 30; page 9, lines 5-32 * | 3,4 | |
| A | | 5,6 | |
| | --- | | |
| X | GB-A-2 081 974 (GAO)<br>* Figure 3; page 2, lines 34-88 * | 1,2 | TECHNICAL FIELDS SEARCHED (Int. Cl.4) |
| A | | 3-6 | H 01 L |
| | --- | | |
| A | US-A-4 151 543 (SHARP K.K.) | | |
| | --- | | |
| A | US-A-4 300 153 (SHARP K.K.) | | |
| | --- | | |
| A | EP-A-0 107 061 (PHILIPS) | | |
| | ----- | | |

The present search report has been drawn up for all claims

| Place of search | Date of completion of the search | Examiner |
|---|---|---|
| THE HAGUE | 02-10-1987 | CAMPLING N.C.G. |